# EUROPÄISCHE PATENTSCHRIFT

(11) **EP 2 656 367 B1**
(45) Veröffentlichungstag und Bekanntmachung des Hinweises auf die Patenterteilung: **27.08.2014**
(21) Anmeldenummer: 11796965.9
(22) Anmeldetag: 08.12.2011
(51) Int. Cl.: H01H 85/046, H05K 1/02

(54) **LEITERBAHNSICHERUNG**
CONDUCTOR FUSE
FUSIBLE DE SÉCURITÉ POUR PISTE CONDUCTRICE

(30) Priorität: 22.12.2010 DE 102010063832
(43) Veröffentlichungstag der Anmeldung: 30.10.2013
(73) Patentinhaber: Tridonic GmbH & Co KG, 6851 Dornbirn (AT)
(72) Erfinder: STEINER, Sascha, A-Dornbirn 6850 (AT)
(74) Vertreter: Rupp, Christian
(86) Internationale Anmeldenummer: PCT/EP2011/072155
(87) Internationale Veröffentlichungsnummer: WO 2012/084525

(56) Entgegenhaltungen:
- WO-A1-02/103735
- DE-A1- 10 005 836
- US-A- 6 002 564
- US-A1- 2002 097 134

## Beschreibung

Die Erfindung betrifft eine Leiterbahnsicherung zur elektrischen Absicherung von elektrischen Geräten.

### Stand der Technik

Leiterbahnsicherungen sind aus dem Stand der Technik bereits bekannt. Sie sind auf einer Leiterplatte bzw. Platine aufgebracht und haben die Aufgabe im Falle eines anormalen Betriebszustands, wie beispielsweise einem Kurzschluss elektrischer Komponenten der Platine, die elektrische Verbindung zur Spannungsversorgung schnell und zuverlässig zu durchbrechen. Dadurch kann insbesondere weiterer Schaden der Platine bzw. an den sich darauf befindlichen elektrischen Komponenten vermieden werden. Des Weiteren ist es möglich, durch ein frühzeitiges Auslösen der Leiterbahnsicherung ein Auslösen eines Netzschutzschalters zu verhindern.

Durch die Bereitstellung einer Leiterbahnsicherung auf einer Platine ist es zudem möglich eine sonst übliche Feinsicherung zur Absicherung elektrischer oder elektronischer Geräte zu ersetzen.

Die Leiterbahnsicherung weist im Allgemeinen wenigstens einen Leiterbahnabschnitt auf, welcher als Schmelzsicherung bzw. Schmelzleiter ausgeführt ist. Dieser Leiterbahnabschnitt hat dabei im Vergleich zu den anderen Leiterbahnen auf der Platine einen verengten Querschnitt. Der Schmelzleiter wird durch den durch ihn durchfließenden Strom erwärmt und schmilzt oder verdampft, wenn der Bemessungsstrom des Schmelzleiters deutlich überschritten wird, was zu einer Stromkreisunterbrechung führt.

Hierbei ist darauf zu achten, dass ein eventuell auftretender Lichtbogen kontrolliert erlöschen und insbesondere keine anderen Leiterzüge erreichen kann. Insbesondere soll verhindert werden, dass beim Schmelzen oder Verdampfen der Schmelzsicherung auftretendes Plasma ein neues, unter Spannung stehendes Kontaktpaar findet und dadurch unkontrolliert weiterbrennt und somit weiteren Schaden auf der Platine verursacht.

DE 100 05 836 B4 beschreibt eine Leiterplatte für ein elektrisches oder elektronisches Gerät mit einer Leiterplattensicherung, wobei die Leiterplatte einen abzusichernden Leiterzug trägt und wobei der Leiterzug einen Bereich mit reduziertem Querschnitt als Durchbrennbereich aufweist und mit einer nichtleitenden Beschichtung versehen ist. Der Leiterzug weist zudem wenigstens zwei im Abstand zueinander auf dem Durchbrennbereich angeordnete, in Leiterzuglängsrichtung voneinander beabstandete und zusätzlich zu der Beschichtung vorgesehene Anhäufungen aus nichtleitendem Material auf.

WO 02/103735 A1 beschreibt eine Leiterbahnsicherung gemäß dem Oberbegriff des Anspruchs 1.

### Aufgabenstellung

Ausgehend von diesem bekannten Stand der Technik ist es Aufgabe der Erfindung, eine kostengünstig zu produzierende Leiterbahnsicherung für eine Leiterplatte bzw. Platine bereitzustellen, welche im Fehlerfall ein gefahrloses und sicheres Abschalten der Stromzufuhr zur Platine ermöglicht und demnach die Betriebssicherheit der Platine verbessert.

Diese Aufgabe wird erfindungsgemäß durch die Merkmale des Anspruchs 1 gelöst. Besonders vorteilhafte Ausführungen der Erfindung sind in den abhängigen Ansprüchen beschrieben.

In einem ersten Aspekt betrifft die vorliegende Erfindung eine Leiterbahnsicherung für ein elektrisches oder elektronisches Gerät, aufweisend einen ersten und zweiten Anschlussbereich, einen zwischen dem ersten und zweiten Anschlussbereich angeordneten, sich nicht linear erstreckenden Durchbrennbereich, und einen zusammenhängenden Abdeckungsbereich, welcher wenigstens jeweils teilweise über dem ersten und zweiten Anschlussbereich und dem Durchbrennbereich angeordnet ist, wobei der Durchbrennbereich und der Abdeckungsbereich derart zueinander angeordnet sind, dass wenigstens ein Auslösebereich des Durchbrennbereichs nicht von dem Abdeckungsbereich abgedeckt, aber beidseitig von dem Abdeckungsbereich begrenzt ist.

Die vorliegende Erfindung ermöglicht die Bereitstellung einer einfach herstellbaren, aber gleichzeitig sehr effizienten Leiterbahnsicherung, mit Hilfe derer die Betriebssicherheit eines elektrischen bzw. elektronischen Geräts erhöht wird.

In einer vorteilhaften Ausführungsform der Erfindung weist der Durchbrennbereich in Draufsicht einen wenigstens teilweise gebogenen oder teilweise zickzackförmigen Verlauf auf. Dieser gebogene oder zickzackförmige Verlauf des Durchbrennbereichs erstreckt sich dabei vorzugsweise entlang einer Haupterstreckungsrichtung des Durchbrennbereichs. Diese Haupterstreckungsrichtung des Durchbrennbereichs entspricht vorzugsweise einer direkten Verbindung des ersten und zweiten Anschlussbereichs der Leiterbahnsicherung in Draufsicht. Der gebogene oder zickzackförmige Verlauf des Durchbrennbereichs erstreckt sich vorzugweise zu beiden Seiten der Haupterstreckungsrichtung des Durchbrennbereichs zu gleichem Ausmaß.

In einer weiteren bevorzugten Ausführungsform kann der gebogene oder zickzackförmige Verlauf auch derart ausgeprägt sein, dass dieser Verlauf des Durchbrennbereichs sich zu einer Seite der Haupterstreckungsrichtung des Durchbrennbereichs weiter erstreckt, als zu einer gegenüberliegenden Seite der Haupterstreckungsrichtung.

Des Weiteren kann der Durchbrennbereich auch einen andersförmigen nicht-linearen Verlauf aufweisen.

Der zusammenhängende Abdeckbereich der Leiterbahnsicherung ist vorzugsweise parallel zu der Haupterstreckungsrichtung des Durchbrennbereichs angeordnet. Der Abdeckbereich ist dabei vorzugsweise linear zwischen dem ersten und zweiten Anschlussbereich angeordnet.

Es ist demnach möglich den Abdeckungsbereich direkt zwischen den ersten und zweiten Anschlussbereich auf die Platine aufzutragen. Der erste und zweite Anschlussbereich ist dabei vorzugsweise jeweils wenigstens teilweise durch den Abdeckungsbereich überdeckt. Hierdurch wird ein vereinfachtes Aufbringen des Abdeckungsbereichs erzielt.

In einer bevorzugten Ausführungsform ist der Abdeckungsbereich homogen ausgebildet. Insbesondere weist der Abdeckungsbereich vorzugsweise eine konstante Dicke auf. Zudem ist der Abdeckungsbereich aus einem zusammenhängenden, homogenen Material hergestellt. Der Abdeckungsbereich ist vorzugsweise ein Balken oder Streifen aus nichtleitendem Material, beispielsweise SMD-Kleber oder Lötstopplack.

In Draufsicht weist der Abdeckungsbereich vorzugsweise eine konstante Breite auf.

Der Abdeckungsbereich ist vorzugsweise ein Film aus nichtleitendem Material. Der Abdeckungsbereich ist dabei mit einer Schablone und anschließendem optionalen Rakeln auf der Platine auftragbar.

Es ist demnach möglich in einem Verfahrensschritt den Abdeckungsbereich über den Durchbrennbereich der Leiterbahnsicherung aufzubringen, ohne die Notwendigkeit weiterer Bearbeitungsschritte. Die Herstellungszeit sowie die Herstellungskosten der Leiterbahnsicherung können somit reduziert werden. Gleichzeitig wird ein zuverlässiger Schutz der Platine mit Hilfe der erfindungsgemäßen Leiterbahnsicherung ermöglicht.

Der Durchbrennbereich der Leiterbahnsicherung ist vorzugsweise ein unverzinnter Kupferleiter, welcher einen gegenüber dem ersten und zweiten Anschlussbereich reduzierten Querschnitt aufweist. Der Durchbrennbereich kann jedoch auch aus einem anderen Material wie beispielsweise Feinsilber gebildet sein. Der Querschnitt des Durchbrennbereichs liegt vorzugsweise zwischen 0,05 und 1 mm.

Der wenigstens eine Auslösebereich des Durchbrennbereichs ist in Draufsicht seitlich des durchgehenden Abdeckungsbereichs angeordnet. Dabei ist der wenigstens eine Auslösebereich von dem Abdeckungsbereich beidseitig begrenzt. Vorteilhafterweise ist demnach zumindest ein nicht-linearer Auslösebereich seitlich des durchgehenden Abdeckungsbereichs angeordnet.

Im Fall einer Beaufschlagung des Durchbrennbereichs mit einem Strom, der dessen Bemessungsstrom deutlich überschreitet, kommt es zum Verdampfen bzw. Schmelzen des Durchbrennbereichs. Hierbei wird die Menge an verdampfbaren Material beim Auslösen minimal gehalten, da nur ein kleiner Bereich des Durchbrennbereichs, nämlich der wenigstens eine Auslösebereich, nicht vom Abdeckungsbereich abgedeckt ist. Der restliche, vom Abdeckungsbereich abgedeckte Teil des Durchbrennbereichs wird beim Auslösen durch das darauf aufgebrachte nichtleitende Material gekühlt. Des Weiteren wird durch den Abdeckungsbereich der Leiterbahnsicherung gewährleistet, dass das dabei entstehende Plasma nicht andere unter Strom stehende Kontaktpaare erreicht.

Auf diese Weise wird eine Leiterbahnsicherung mit definiertem Auslösebereich bereitgestellt, wobei das entstehende Plasma beim Verdampfen des Durchbrennbereichs möglichst gering gehalten wird.

In einer bevorzugten Ausführungsform liegt das flächenmäßige Verhältnis des Auslösebereich des Durchbrennbereichs zum abgedeckten Teil des Durchbrennbereichs zwischen 1/3 und 1/9.

Der wenigstens eine Auslösebereich kann eine Isolierung oder eine Isolationsschicht aufweisen. Diese ist vorzugsweise in einer zusätzlichen Schicht auf den wenigstens einen Auslösebereich aufgetragen. Die Isolierung kann dabei den Auslösebereich und/oder den Abdeckungsbereich wenigstens teilweise überdecken. Dabei kann die Isolationsschicht beispielsweise aus Epoxidharz oder eine Silikonverbindung sein.

In einem zweiten Aspekt beschreibt die vorliegende Erfindung eine Leiterplatte aufweisend eine Leiterbahnsicherung mit den oben beschriebenen Merkmalen.

Die vorliegende Erfindung ermöglicht demnach die Erhöhung der Betriebssicherheit der Leiterplatte mit einer einfach herstellbaren Leiterbahnsicherung.

In einem weiteren Aspekt beschreibt die vorliegende Erfindung eine Betriebsschaltung für Leuchtmittel aufweisend eine erfindungsgemäße Leiterbahnsicherung.

### Ausführungsbeispiele

Vorteilhafte Ausführungsbeispiele der vorliegenden Erfindung sind in den folgenden Figuren darstellt und werden anhand der nachfolgenden Beschreibung näher erläutert.
- Fig. 1: zeigt eine schematische Draufsicht der erfindungsgemäßen Leiterbahnsicherung gemäß einem ersten Ausführungsbeispiel.
- Fig. 2: zeigt eine schematische Draufsicht der erfindungsgemäßen Leiterbahnsicherung gemäß einem zweiten Ausführungsbeispiel.
- Fig. 3: zeigt eine schematische Draufsicht der erfindungsgemäßen Leiterbahnsicherung gemäß einem dritten Ausführungsbeispiel.
- Fig. 4: zeigt eine schematische Seitenansicht der erfindungsgemäßen Leiterbahnsicherung gemäß den Figuren 1 bis 3.
- Fig. 5: zeigt eine Leiterplatte eines elektrischen oder elektronischen Geräts aufweisend eine erfindungsgemäße Leiterbahnsicherung.

### Detaillierte Beschreibung der Ausführungsbeispiele

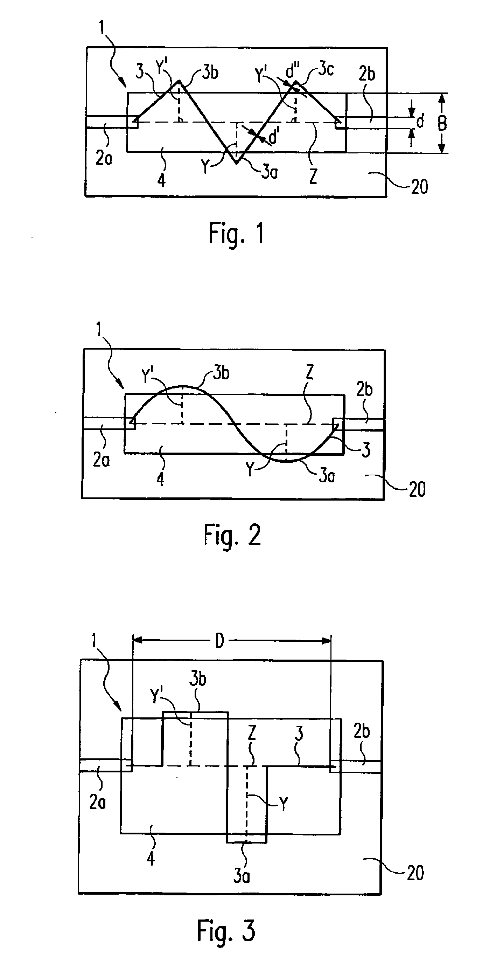

Figur 1 zeigt eine schematische Draufsicht der erfindungsgemäßen Leiterbahnsicherung 1 gemäß einem ersten Ausführungsbeispiel. Die Leiterbahnsicherung 1 ist auf einer Leiterplatte bzw. Platine 20 aufgebracht und weist einen ersten und zweiten Anschlussbereich 2a,2b auf. Die Anschlussbereiche 2a,2b sind in einem Abstand D (siehe Figur 3) angeordnet, welcher vorzugsweise zwischen 3 und 15 mm beträgt.

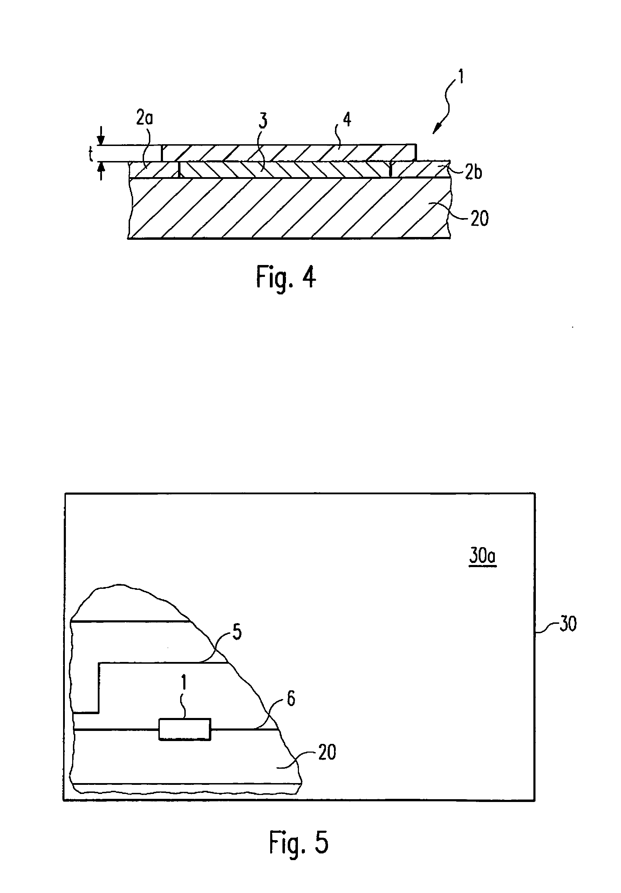

Zwischen dem ersten und zweiten Abschlussbereich 2a,2b ist ein Durchbrennbereich 3 angeordnet, welcher elektrisch mit diesen kontaktiert ist. Der Durchbrennbereich weist einen Querschnitt d' auf, welcher gegenüber dem Querschnitt d des ersten und zweiten Anschlussbereichs 2a,2b verringert ist. Vorteilhafterweise ist der Querschnitt d' des Durchbrennbereichs 3 auch gegenüber den übrigen sich auf der Platine 20 befindlichen Leiterbahnen 5,6 (siehe Figur 5) verringert.

Der Querschnitt d' des Durchbrennbereichs 3 ist dabei derart dimensioniert, dass der Durchbrennbereich bei einer Überschreitung des Bemessungsstroms der Leiterbahnsicherung 1 verdampft bzw. schmilzt.

Der Durchbrennbereich 3 ist vorzugsweise nicht-linear zwischen dem ersten und zweiten Anschlussbereich 2a,2b angeordnet. In einer bevorzugten Ausführungsform weist der Durchbrennbereich 3 einen zickzackförmigen Verlauf auf, welcher sich entlang einer Haupterstreckungsrichtung Z erstreckt.

Die Haupterstreckungsrichtung Z entspricht dabei vorzugsweise der direkten bzw. der kürzesten Verbindung des ersten und zweiten Anschlussbereichs 2a,2b.

Der zickzackförmige Verlauf des Durchbrennbereichs 3 erstreckt sich vorzugsweise zu gleichem Ausmaß Y, Y' zu beiden Seiten der Haupterstreckungsrichtung Z. Es ist jedoch auch möglich, dass sich der zickzackförmige Verlauf zu unterschiedlichem Ausmaß Y,Y' von der Haupterstreckungsrichtung Z erstreckt.

Über den ersten und zweiten Anschlussbereich 2a,2b sowie über dem Durchbrennbereich 3 ist ein Abdeckungsbereich 4 angeordnet. Dieser überdeckt in Draufsicht wenigstens teilweise den ersten und zweiten Anschlussbereich 2a,2b und den Durchbrennbereich 3.

In den Figuren 1 bis 3 ist zum besseren Verständnis der Abdeckbereich 4 durchsichtig dargestellt. Dementsprechend sind die sich darunter befindlichen Leiterbahnen des Durchbrennbereichs 3 sowie den ersten und zweiten Anschlussbereich 2a,2b vollständig sichtbar.

Der Abdeckungsbereich 4 ist vorzugsweise bezüglich des Durchbrennbereichs 3 derart angeordnet, dass wenigstens ein Auslösebereich 3a des Durchbrennbereichs 3 nicht von dem Abdeckungsbereich 4 überdeckt ist. Der wenigstens eine Auslösebereich 3a kann demnach im Falle einer Beaufschlagung der Leiterbahnsicherung mit einem Strom, welcher deutlich über dem Bemessungsstrom liegt möglichst schnell und kontrolliert verdampfen bzw. schmelzen, ohne dass das dabei entstehende Plasma auf weitere leitende bzw. unter Strom stehende Kontakte der Leiterbahnsicherung übergreift. Dies wird insbesondere durch den Abdeckungsbereich 4 vermieden, welcher zu beiden Seiten den wenigstens einen Auslösebereich 3a der Leiterbahnsicherung begrenzt.

Ein Verdampfen bzw. Schmelzen unter Entstehung von Plasma des restlichen Durchbrennbereichs 3 wird durch den Abdeckungsbereich 4 vermieden, welcher die darunterliegenden Leiterbahnen 3 kühlt.

Der Querschnitt d'' des wenigstens einen Auslösebereichs 3a ist vorzugsweise gleich dem Querschnitt d' des Durchbrennbereichs 3.

In einer alternativen Ausführungsform weist der wenigstens eine Auslösebereich 3a einen gegenüber dem Querschnitt d' des Durchbrennbereichs 3 weiter reduzierten Querschnitt d" auf.

In einer bevorzugten Ausführungsform weist die Leiterbahnsicherung 1 mehrere Auslösebereiche 3a auf. Vorzugsweise sind drei Auslösebereiche 3a,3b,3c vorhanden, welche jeweils von dem Abdeckungsbereich 4 zu beiden Seiten begrenzt sind.

Der Abdeckungsbereich 4 ist linear zwischen dem ersten und zweiten Anschlussbereich 2a,2b und damit der Haupterstreckungsrichtung Z des Durchbrennbereichs 3 folgend auf der Platine 20 angeordnet. Der Abdeckungsbereich 4 ist dabei von konstanter Breite B. Die Breite B ist vorzugsweise kleiner als die Summe der Erstreckungslängen Y und Y' des Durchbrennbereichs 3, welche rechtwinklig bezüglich der Haupterstreckungsrichtung Z angeordnet sind.

Der Abdeckungsbereich 4 ist ferner vorzugsweise mittig bezüglich der Haupterstreckungsrichtung Z auf der Platine 20 angeordnet.

Figur 2 und 3 zeigen eine schematische Draufsicht der erfindungsgemäßen Leiterbahnsicherung gemäß einem zweiten und dritten Ausführungsbeispiel. Dieses Ausführungsbeispiel entspricht im Wesentlichen dem Ausführungsbeispiel gemäß Figur 1, wobei die gleichen Bauteile mit gleichen Bezugszeichen versehen sind.

Gemäß dem in Figur 2 gezeigten Ausführungsbeispiel weist der Durchbrennbereich 3 einen wenigstens teilweise gebogenen Verlauf auf. Der wenigstens eine Auslösebereich 3a ist hierbei wiederum durch den Abdeckungsbereich 4 zu beiden Seiten begrenzt.

Ein weiteres bevorzugtes Ausführungsbeispiel wird in Figur 3 gezeigt, wobei der Durchbrennbereich 3 wenigstens teilweise einen eckigen bzw. rechtwinkligen Verlauf aufweist.

Figur 4 zeigt eine schematische Seitenansicht der erfindungsgemäßen Leiterbahnsicherung gemäß den Figuren 1 und 2. Wie in dieser Figur dargestellt, sind die ersten und zweiten Anschlussbereiche 2a,2b direkt auf die Platine 20 aufgebracht. Ebenso ist der zwischen der ersten und zweiten Anschlussbereichen 2a,2b angeordnete Durchbrennbereich 3 direkt auf die Platine 20 aufgebracht.

Der Abdeckungsbereich 4 ist in einer weiteren Schicht wenigstens über der gesamten Länge des Durchbrennbereichs 3 aufgebracht. Der Abdeckungsbereich 4 erstreckt sich somit wenigstens durchgehend entlang der gesamten Haupterstreckungsrichtung Z zwischen dem ersten und zweiten Anschlussbereich 2a,2b.

Der Abdeckungsbereich 4 weist dabei eine vorzugsweise gleiche Dicke t auf. Diese liegt vorzugsweise zwischen 0,3 und 2 mm.

Die erfindungsgemäße Leiterbahnsicherung kann somit vereinfacht hergestellt werden. Hierbei werden die Anschlussbereiche 2a,2b, welche vorzugsweise mit weiteren Leiterbahnen der Platine 20 elektrisch verbunden sind, zusammen mit diesen auf die Platine 20 aufgetragen. In dem gleichen oder in einem direkt darauf folgenden Verfahrensschritt kann die den Durchbrennbereich 3 bildende Leiterbahn zwischen den ersten und zweiten Anschlussbereich 2a,2b auf die Platine 20 aufgebracht werden.

Unter "Aufbringen" der Leiterbahnen auf die Leiterplatte 20 ist insbesondere auch ein Ätzen der jeweiligen Leiterbahn aus einer dünnen sich auf der Leiterplatte befindlichen Kupferschicht zu verstehen.

In einem anschließenden Verfahrensschritt kann der Abdeckungsbereich 4 über den Durchbrennbereich 3 aufgetragen werden. Dabei wird der Abdeckungsbereich 4 vorzugsweise mit Hilfe einer Schablone aufgetragen. In einem gleichzeitigen Schritt kann durch Rakeln eine gleichmäßige Dicke des Abdeckungsbereichs 4 erzielt werden.

Der wenigstens eine Auslösebereich 3a,3b,3c kann optional mit einer zusätzlichen Schicht aus Isoliermaterial (nicht dargestellt) überzogen sein. Diese kann vor oder nach dem Auftrag des Abdeckungsbereichs 4 auf die Platine 20 aufgetragen werden. Das Isoliermaterial kann somit als Korrosions- oder Berührungsschutz dienen.

Der Abdeckungsbereich 4 ist wie in Figur 4 ersichtlich filmartig ausgeprägt und dabei vorzugsweise aus einem nichtleitenden Material, beispielsweise Lötstopplack oder SMD-Kleber.

Der Abdeckungsbereich 4 und/oder die optionale Isolationsschicht können zudem lichtbogenlöschende Substanzen enthält.

Wenn der Abdeckungsbereich 4 durch SMD-Kleber gebildet ist, erfolgt der Auftrag des Abdeckungsbereichs 4 vorzugsweise in einem Schritt mit den auf die Platine 20 aufzutragenden Klebepunkten während der Herstellung der Platine.

Die selektive Abdeckung des Durchbrennbereichs 3 mit Hilfe des Abdeckungsbereichs 4 kann somit in einem Schritt mit dem Auftrag der Klebepunkte auf die Platine 20 erfolgen.

Es ist somit ein vereinfachter Herstellungsprozess der Leiterplatte 20 möglich.

Figur 5 zeigt ein Vorschaltgerät 30 für Leuchtmittel aufweisend eine Platine 20, auf welcher die die Betriebsschaltung des Leuchtmittels bildenden Leiterbahnen 5,6 aufgebracht sind. Das Vorschaltgerät 30 weist dabei eine erfindungsgemäße Leiterbahnsicherung 1 auf.

Die Platine 20 befindet sich dabei im Inneren eines Gehäuses 30a des Geräts 30. Die Leiterbahnen 5,6 stehen in Kontakt mit einer nicht dargestellten externen Stromversorgung, zum Beispiel ein 230V Netz.

Die Leiterbahn 6 ist mit einer erfindungsgemäßen Leiterbahnsicherung 1 elektrisch kontaktiert. Hierdurch wird eine elektrische Absicherung der Leiterbahn 6 und damit des elektrischen Geräts 30 ermöglicht. Ein in der Schaltung entstehender Kurzschluss oder ein anormaler Betriebszustand, der zu einem den Bemessungsstrom der Leiterbahnsicherung 1 deutlich übersteigenden Strom in den Leiterbahnen 5, 6 führt, kann somit sicher durch die Leiterbahnsicherung 1 unterbrochen werden.

## Patentansprüche

1. Leiterbahnsicherung (1) für ein elektrisches oder elektronisches Gerät, aufweisend einen ersten und zweiten Anschlussbereich (2a,2b), einen zwischen dem ersten und zweiten Anschlussbereich (2a,2b) angeordneten, sich nicht linear erstreckenden Durchbrennbereich (3), und einen zusammenhängenden Abdeckungsbereich (4), welcher wenigstens jeweils teilweise über dem ersten und zweiten Anschlussbereich (2a,2b) und dem Durchbrennbereich (3) angeordnet ist, wobei der Durchbrennbereich (3) und der Abdeckungsbereich (4) derart zueinander angeordnet sind, dass wenigstens ein Auslösebereich (3a) des Durchbrennbereichs (3) nicht von dem Abdeckungsbereich (4) abgedeckt, aber beidseitig von dem Abdeckungsbereich begrenzt ist, wobei
dass der zusammenhängende Abdeckungsbereich (4) parallel zu einer Haupterstreckungsrichtung (Z) des Durchbrennbereichs (3) angeordnet ist, wobei die Haupterstreckungsrichtung (Z) einer direkten Verbindung des ersten und zweiten Anschlussbereiches (2a, 2b) in Draufsicht entspricht; **dadurch gekennzeichnet dass** der Abdeckungsbereich (4) in Draufsicht eine konstante Breite (B) aufweist.

2. Leiterbahnsicherung nach Anspruch 1, **dadurch gekennzeichnet, dass** der Durchbrennbereich (3) in Draufsicht einen zickzackförmigen Verlauf aufweist.

3. Leiterbahnsicherung nach Anspruch 1, **dadurch gekennzeichnet, dass** der Durchbrennbereich (3) in Draufsicht einen wenigstens teilweise gebogenen oder eckigen Verlauf aufweist.

4. Leiterbahnsicherung nach einem der vorhergehenden Ansprüche, **dadurch gekennzeichnet, dass** der Durchbrennbereich (3) einen gegenüber dem ersten und zweiten Anschlussbereich (2a,2b) reduzierten Querschnitt (d') aufweist.

5. Leiternbahnsicherung nach einem der vorhergehenden Ansprüche, **dadurch gekennzeichnet, dass** der Abdeckungsbereich (4) homogen ausgebildet ist und eine konstante Dicke (t) aufweist.

6. Leiterbahnsicherung nach einem der vorhergehenden Ansprüche, **dadurch gekennzeichnet, dass** der wenigstens eine Auslösebereich (3a) des Durchbrennbereichs (3) in Draufsicht seitlich des durchgehenden Abdeckungsbereichs (4) angeordnet ist.

7. Leiterbahnsicherung nach einem der vorhergehenden Ansprüche, **dadurch gekennzeichnet, dass** der wenigstens eine Auslösebereich (3a) eine Isolierung aufweist.

8. Leiterbahnsicherung nach einem der vorhergehenden Ansprüche, **dadurch gekennzeichnet, dass** der Durchbrennbereich (3) ein unverzinnter Kupferleiter ist.

9. Leiterbahnsicherung nach einem der vorhergehenden Ansprüche, **dadurch gekennzeichnet, dass** der Abdeckungsbereich (4) ein Balken oder Streifen aus nichtleitendem Material, vorzugsweise SMD-Kleber oder Lötstopplack ist.

10. Leiterbahnsicherung nach einem der vorhergehenden Ansprüche, **dadurch gekennzeichnet, dass** der Abdeckungsbereich (4) mit Hilfe einer Schablone auftragbar ist.

11. Leiterbahnsicherung nach einem der vorhergehenden Ansprüche, **dadurch gekennzeichnet, dass** der Verlauf des Durchbrennbereichs (3) sich zu einer Seite der Haupterstreckungsrichtung (Z) weiter erstreckt, als zu einer gegenüberliegenden Seite der Haupterstreckungsrichtung (Z).

12. Leiterbahnsicherung nach einem der vorhergehenden Ansprüche, **dadurch gekennzeichnet, dass** das Verhältnis des Auslösebereichs (3a) des Durchbrennbereichs (3) zum abgedeckten Bereich des Durchbrennbereichs (3) zwischen 1/3 und 1/9 ist.

13. Leiterbahnsicherung nach einem der vorhergehenden Ansprüche, **dadurch gekennzeichnet, dass** der Querschnitt (d'') des Auslösebereichs (3a) des Durchbrennbereichs (3) geringer ist als der Querschnitt (d') des abgedeckten Bereichs des Durchbrennbereichs (3).

14. Leiterplatte aufweisend eine Leiterbahnsicherung gemäß einem der Ansprüche 1 bis 13.

15. Betriebsschaltung für Leuchtmittel aufweisend eine Leiterbahnsicherung gemäß einem der Ansprüche 1 bis 13.

## Claims

1. Conductor track fuse (1) for an electrical or electronic appliance, having a first and a second connection region (2a, 2b), a bum-out region (3) which is arranged between the first and the second connection region (2a, 2b) and does not extend in a linear manner, and a cohesive covering region (4) which is arranged at least in each case partially above the first and the second connection region (2a, 2b) and the burn-out region (3), wherein the bum-out region (3) and the covering region (4) are arranged in relation to one another in such a way that at least one trip region (3a) of the bum-out region (3) is not covered by the covering region (4) but is bounded on both sides by the covering region, wherein the cohesive covering region (4) is arranged parallel to a main direction (Z) of extent of the burn-out region (3), wherein the main direction (Z) of extent corresponds to a direct connection of the first and the second connection region (2a, 2b) in plan view; **characterized in that** the covering region (4) has a constant width (B) in plan view.

2. Conductor track fuse according to Claim 1, **characterized in that** the burn-out region (3) has a zigzag profile in plan view.

3. Conductor track fuse according to Claim 1, **characterized in that** the burn-out region (3) has an at least partially bent or angled profile in plan view.

4. Conductor track fuse according to one of the preceding claims, **characterized in that** the bum-out region (3) has a cross section (d') which is reduced in comparison to the first and the second connection region (2a, 2b).

5. Conductor track fuse according to one of the preceding claims, **characterized in that** the covering region (4) is of homogeneous design and has a constant thickness (t).

6. Conductor track fuse according to one of the preceding claims, **characterized in that** the at least one trip region (3a) of the burn-out region (3) is arranged to the side of the continuous covering region (4) in plan view.

7. Conductor track fuse according to one of the preceding claims, **characterized in that** the at least one trip region (3 a) has an insulation.

8. Conductor track fuse according to one of the preceding claims, **characterized in that** the bum-out region (3) is a bare copper conductor.

9. Conductor track fuse according to one of the preceding claims, **characterized in that** the covering region (4) is a bar or strip which is composed of non-conducting material, preferably SMD adhesive or solder stop finish.

10. Conductor track fuse according to one of the preceding claims, **characterized in that** the covering region (4) can be applied with the aid of a stencil.

11. Conductor track fuse according to one of the preceding claims, **characterized in that** the profile of the bum-out region (3) extends further to one side of the main direction (Z) of extent than to an opposite side of the main direction (Z) of extent.

12. Conductor track fuse according to one of the preceding claims, **characterized in that** the ratio of the trip region (3a) of the bum-out region (3) to the covered region of the burn-out region (3) is between 1/3 and 1/9.

13. Conductor track fuse according to one of the preceding claims, **characterized in that** the cross section (d") of the trip region (3a) of the bum-out region (3) is smaller than the cross section (d') of the covered region of the burn-out region (3).

14. Printed circuit board having a conductor track fuse according to one of Claims 1 to 13.

15. Operating circuit for lighting means having a conductor track fuse according to one of Claims 1 to 13.

## Revendications

1. Fusible de piste conductrice (1) pour un appareil électrique ou électronique, présentant une première et une deuxième zone de raccordement (2a, 2b), une zone fusible (3) disposée entre la première et la deuxième zone de raccordement (2a, 2b) et ne s'étendant pas linéairement, et une zone de couverture (4) d'un seul tenant, laquelle est disposée au moins respectivement partiellement au-dessus de la première et de la deuxième zone de raccordement (2a, 2b) et de la zone fusible (3),
dans lequel la zone fusible (3) et la zone de couverture (4) sont disposées l'une par rapport à l'autre de telle sorte qu'au moins une zone de déclenchement (3a) de la zone fusible (3) n'est pas recouverte par la zone de couverture (4) mais est délimitée de chaque côté par la zone de couverture,
dans lequel la zone de couverture (4) d'un seul tenant est disposée parallèlement à une direction principale d'extension (Z) de la zone fusible (3), dans lequel la direction principale d'extension (Z) correspond à une liaison directe de la première et de la deuxième zone de raccordement (2a, 2b) en vue de dessus ;
**caractérisé en ce que** la zone de couverture (4) présente, en vue de dessus, une largeur (B) constante.

2. Fusible de piste conductrice selon la revendication 1, **caractérisé en ce que** la zone fusible (3) présente en vue de dessus un profil en forme de zigzag.

3. Fusible de piste conductrice selon la revendication 1, **caractérisé en ce que** la zone fusible (3) présente en vue de dessus un profil au moins partiellement courbé ou angulaire.

4. Fusible de piste conductrice selon l'une des revendications précédentes, **caractérisé en ce que** la zone fusible (3) présente une coupe transversale (d') réduite par rapport à la première et à la deuxième zone de raccordement (2a, 2b).

5. Fusible de piste conductrice selon l'une des revendications précédentes, **caractérisé en ce que** la zone de couverture (4) est formée de manière homogène et présente une épaisseur (t) constante.

6. Fusible de piste conductrice selon l'une des revendications précédentes, **caractérisé en ce que** ladite au moins une zone de déclenchement (3a) de la zone fusible (3) est disposée en vue de dessus latéralement à la zone de couverture (4) continue.

7. Fusible de piste conductrice selon l'une des revendications précédentes, **caractérisé en ce que** ladite au moins une zone de déclenchement (3a) présente une isolation.

8. Fusible de piste conductrice selon l'une des revendications précédentes, **caractérisé en ce que** la zone fusible (3) est un conducteur en cuivre non étamé.

9. Fusible de piste conductrice selon l'une des revendications précédentes, **caractérisé en ce que** la zone de couverture (4) est une barre ou une bande en matériau non conducteur, de préférence un adhésif SMD ou un vernis d'arrêt de soudure.

10. Fusible de piste conductrice selon l'une des revendications précédentes, **caractérisé en ce que** la zone de couverture (4) est apte à être appliquée à l'aide d'un modèle.

11. Fusible de piste conductrice selon l'une des revendications précédentes, **caractérisé en ce que** le profil de la zone fusible (3) s'étend davantage vers un côté de la direction principale d'extension (Z) que vers un côté opposé de la direction principale d'extension (Z).

12. Fusible de piste conductrice selon l'une des revendications précédentes, **caractérisé en ce que** le rapport de la zone de déclenchement (3a) de la zone fusible (3) par rapport à la zone recouverte de la zone fusible (3) est compris entre 1/3 et 1/9.

13. Fusible de piste conductrice selon l'une des revendications précédentes, **caractérisé en ce que** la coupe transversale (d") de la zone de déclenchement (3a) de la zone fusible (3) est plus petite que la coupe transversale (d') de la zone recouverte de la zone fusible (3).

14. Circuit imprimé présentant un fusible de piste conductrice selon l'une des revendications 1 à 13.

15. Circuit de commande pour moyen(s) d'éclairage présentant un fusible de piste conductrice selon l'une des revendications 1 à 13.
